# EUROPÄISCHE PATENTSCHRIFT

(11) **EP 3 408 866 B1**
(45) Veröffentlichungstag und Bekanntmachung des Hinweises auf die Patenterteilung: **15.11.2023**
(21) Anmeldenummer: 17707228.7
(22) Anmeldetag: 22.02.2017
(51) Int. Cl.: H01L 31/0203, H01L 31/167, H01L 31/02, H01L 31/0232

(54) **OPTOELEKTRONISCHE VORRICHTUNG MIT IDENTIFIKATIONSELEMENT**
OPTOELECTRONIC DEVICE HAVING AN IDENTIFICATION ELEMENT
DISPOSITIF OPTOÉLECTRONIQUE AYANT UNE ÉLÉMENT D'IDENTIFICATION

(30) Priorität: 23.02.2016 DE 102016103113
(43) Veröffentlichungstag der Anmeldung: 05.12.2018
(73) Patentinhaber: Vishay Semiconductor GmbH, 74072 Heilbronn (DE)
(72) Erfinder: BURGER, Daniel, 74211 Leingarten (DE); KUHN, Sascha, 74229 Oedheim (DE); MÜHLECK, Peter, 74254 Offenau (DE)
(74) Vertreter: Manitz Finsterwald Patent- und Rechtsanwaltspartnerschaft mbB
(86) Internationale Anmeldenummer: PCT/EP2017/054051
(87) Internationale Veröffentlichungsnummer: WO 2017/144527

(56) Entgegenhaltungen:
- EP-A1- 2 568 444
- WO-A1-2012/101547
- DE-A1-102006 005 519
- DE-A1-102007 025 458
- DE-U1-202014 104 049
- GB-A- 2 452 073
- US-A- 5 170 047

## Beschreibung

Die vorliegende Erfindung betrifft ein System mit mehreren verschiedenen optoelektronischen Vorrichtungen. Die jeweilige optoelektronische Vorrichtung umfasst eine Trägereinrichtung, die an einer Oberseite wenigstens einen optoelektronischen Sender und/oder wenigstens einen optoelektronischen Empfänger aufweist. Die Trägereinrichtung kann zugleich zur elektrischen Kontaktierung des optoelektronischen Senders und/oder des optoelektronischen Empfängers dienen. Oberhalb der Trägereinrichtung, d.h. bezüglich einer Vertikalrichtung oberhalb des Senders und/oder Empfängers, ist ein Linsenelement vorgesehen, welches wenigstens einen Linsenabschnitt für den wenigstens einen optoelektronischen Sender und/oder den wenigstens einen optoelektronischen Empfänger aufweist. Hierfür kann der jeweilige Linsenabschnitt strahlformende und/oder strahlumlenkende Eigenschaften aufweisen. Die Vorrichtung weist ferner eine Halteeinrichtung auf, welche die Trägereinrichtung und das Linsenelement relativ zueinander hält und teilweise umgibt.

Derartige optoelektronische Vorrichtungen sind insbesondere als optoelektronische Sensorvorrichtungen ausgebildet, um Eigenschaften von Objekten optisch abtasten und elektronisch erfassen zu können. Ein Anwendungsfall für solche Sensorvorrichtungen liegt im Bereich von kommerziell erhältlichen Druckergeräten, d.h. Vorrichtungen zum computergestützten Bedrucken von Papier mittels bekannter Drucktechnologien, z.B. der Laserdruck- oder Tintenstrahldrucktechnologie. Um einen möglichst vollautomatischen und benutzerfreundlichen Betrieb eines Druckers (oder eines einen Drucker umfassenden Multifunktionsgeräts) zu ermöglichen, müssen verschiedene Betriebsparameter des Druckers, wie etwa eine Menge oder den Typ des in ein Aufnahmefach des Druckers eingelegten Papiers, ein vorgesehenes Papierformat, die relative Position einer Papierkante und dergleichen ermittelt und gegebenenfalls überwacht werden. Ferner besteht Bedarf an einer automatischen Analyse eines jeweiligen Druckergebnisses oder eines zu scannenden Papiers, um z.B. den Inhaltstyp (Bild vs. Text) des zu scannenden Papiers oder die korrekte Konfigurierung (z.B. mechanische Ausrichtung einer Druckeinheit des Druckers) anhand eines Druckergebnisses zu überprüfen.

Typischerweise ist für jeden zu messenden Betriebsparameter eine individuell angepasste optoelektronische Vorrichtung vorgesehen, welche dazu ausgebildet ist, ein emittiertes optisches Signal mit einem detektierten, z.B. reflektierten optischen Signal zu vergleichen, um aus der Differenz dieser optischen Signale den betreffenden Betriebsparameter bestimmen können. Bei den optischen Signalen handelt es sich im Allgemeinen um elektromagnetische Strahlung einer sichtbaren oder unsichtbaren Wellenlänge, insbesondere Infrarot. Häufig umfasst die Vorrichtung sowohl einen optoelektronischen Sender als auch (wenigstens) einen optoelektronischen Empfänger. So kann die Vorrichtung beispielsweise als Näherungssensor fungieren. Es sind aber auch Varianten möglich, in denen eine optoelektronische Vorrichtung lediglich einen optoelektronischen Sender oder lediglich einen optoelektronischen Empfänger (für eine passive Detektion) aufweist. Ferner sind Vorrichtungen mit mehreren Sendern und Empfängern möglich, wobei eine Vorrichtung z.B. mehrere Betriebsparameter insbesondere zeitgleich bestimmen kann (z.B. mit einer Unterscheidung zwischen diffuser und spiegelnder Reflexion).

Aufgrund der Vielzahl zu messender Betriebsparameter ist eine entsprechende Vielfalt von optoelektronischen Vorrichtungen erforderlich, was mit einem unerwünschten Kostenaufwand in der Herstellung und Lagerhaltung verbunden ist. Außerdem muss eine optotelektronische Vorrichtung zur Messung eines jeweiligen Betriebsparameters spezifische optische Eigenschaften erfüllen, welche in Abhängigkeit von dem betreffenden Betriebsparameter sehr unterschiedlich sein können und diesbezüglich einen hohen Entwicklungsaufwand erfordern. Als optische Eigenschaften sind insbesondere die Führung und Formung von Strahlen bzw. optischen Signalen zu verstehen, welche zur Messung des jeweiligen Betriebsparameters von dem optoelektronischen Sender ausgesendet und/oder von dem optoelektronischen Empfänger empfangen werden.

Ferner besteht ein praktisches Problem darin, die unterschiedlichen Typen oder Arten von Vorrichtungen insbesondere im Zuge ihrer Montage voneinander unterscheiden zu können. Dieses Problem ist insbesondere dann gegeben, wenn eine Vielzahl von unterschiedlichen optoelektronischen Vorrichtungen gemeinsam in einem (Drucker-) Gerät montiert werden müssen, wobei die Vorrichtungen äußerlich ähnlich sind und deswegen leicht vertauscht werden können. Eine fälschlicherweise montierte Vorrichtung würde jedoch zu einer unter Umständen gravierenden Fehlfunktion des betreffenden Gerätes führen.

Um das Verwechslungsrisiko zwischen unterschiedlichen optoelektronischen Vorrichtungen zu reduzieren, können die betreffenden Vorrichtungen z.B. mit einem jeweiligen Aufkleber oder einer farblichen Kennzeichnung versehen werden. Derartige Kennzeichnungen können jedoch leicht falsch interpretiert und nicht ohne weiteres automatisch detektiert werden. Entsprechende Zusatzmaßnahmen sind ferner aufwändig und führen zu höheren Herstellungskosten für die verschiedenen Vorrichtungen.

Die Patentveröffentlichung DE 10 2006 005 519 A1 offenbart eine optoelektronische Vorrichtung der genannten Art. Weitere Vorrichtungen mit ähnlichen struktuerellen Merkmalen sind in DE 20 2014 104 049 U1 sowie US 5 170 047 A beschrieben. Aus EP 2 568 444 A1 ist ein System mit mehreren optoelektronischen Vorrichtungen bekannt.

Es ist eine Aufgabe der Erfindung, ein System mit mehreren verschiedenen optoelektronischen Vorrichtungen der eingangs genannten Art bereitzustellen, welches eine eindeutige Identifizierung der jeweiligen Vorrichtung erlaubt, um insbesondere die Verwechslungsgefahr zwischen zwei unterschiedlichen Vorrichtungstypen und das Risiko einer Fehlmontage zu minimieren.

Die Aufgabe wird gelöst durch ein System mit den Merkmalen des Anspruchs 1.

Bei dem System mit mehreren verschiedenen optoelektronischen Vorrichtungen weist das jeweilige Linsenelement einen mechanischen Kodierabschnitt auf, der aus der Halteeinrichtung herausragt und der wenigstens ein Kodierelement zur Identifizierung der optoelektronischen Vorrichtung aufweist. Die mechanischen Kodierabschnitte der Linsenelemente von wenigstens einigen der verschiedenen optoelektronischen Vorrichtungen sind unterschiedlich ausgebildet.

Die Kodierabschnitte unterscheiden sich bezüglich eines Kodierelements oder mehrerer Kodierelemente. Die verschiedenen Vorrichtungen können somit trotz eines modularen Aufbaus mit gleichartigen Elementen zuverlässig und auf einfache Weise voneinander unterschieden werden, wobei jede Vorrichtung aufgrund des Kodierabschnitts eindeutig identifiziert werden kann.

Vorzugsweise bezieht sich die Identifizierung der optoelektronischen Vorrichtung auf einen zugrundeliegenden Vorrichtungstyp, d.h. ein jeweiliges Kodierelement identifiziert eine Gruppe (z.B. eine Klasse oder eine Art) von Vorrichtungen. Alternativ kann ein Kodierelement aber auch zur Identifizierung einer spezifischen, d.h. individuellen optoelektronischen Vorrichtung dienen. Hierbei kann ein Kodierelement beispielsweise einem bestimmten Merkmal oder einer bestimmten Merkmalskombination der Vorrichtung zugeordnet sein.

Der Kodierabschnitt des Linsenelements kann insbesondere derart aus der Halteeinrichtung herausragen, dass der Kodierabschnitt von außen für ein mechanisches oder optisches Abtasten zugänglich ist, wenn die optoelektronische Vorrichtung vollständig zusammengesetzt ist. Der Kodierabschnitt des Linsenelements kann insbesondere derart aus der Halteeinrichtung seitlich herausragen, dass der Kodierabschnitt - in Vertikalrichtung betrachtet - über einen Bodenabschnitt der Halteeinrichtung übersteht.

Das an dem Kodierabschnitt vorgesehene Kodierelement ist vorzugsweise von außen gut ersichtlich und/oder manuell ertastbar. Die Vorrichtung ist somit unmittelbar visuell bzw. optisch und/oder taktil identifizierbar, was die Verwechslungsgefahr zwischen unterschiedlichen Vorrichtungstypen insbesondere während einer Montage besonders wirksam reduziert. Da der Kodierabschnitt aus der Halteeinrichtung herausragt, wird die unmittelbare Identifizierbarkeit zusätzlich begünstigt. Insbesondere kann das jeweilige Kodierelement dazu angepasst sein, maschinell erfasst zu werden, um eine automatisierte Identifizierung der optoelektronischen Vorrichtung zu ermöglichen. Der Kodierabschnitt kann integral, d.h. einteilig, mit dem Linsenelement ausgebildet sein. Alternativ ist es auch denkbar, den Kodierabschnitt fest oder lösbar, beispielsweise mittels einer Rastverbindung, mit dem Linsenelement zu verbinden, wodurch dieses bzw. der Kodierabschnitt erforderlichenfalls ausgetauscht werden kann.

Das Kodierelement kann alternativ oder zusätzlich zu einer aktiven, insbesondere optischen und/oder taktilen Identifizierung durch einen Monteur oder durch eine maschinelle Erfassungseinrichtung auch für eine passive Identifizierung verwendet werden, um eine Falschmontage der optoelektronischen Vorrichtung basierend auf dem sogenannten "Poka-Yoke-Prinzip" mechanisch weitgehend auszuschlie-ßen. Gemäß dem Poka-Yoke-Prinzip ist ein passender Formschluss mit der Montageumgebung bzw. dem Untergrund erforderlich, damit ein Montieren der optoelektronischen Vorrichtung mechanisch überhaupt möglich ist. So kann ein in der Montageumgebung vorgesehenes, komplementär zu dem Kodierelement ausgebildetes Dekodierelement dazu verwendet werden, dass nur die Vorrichtung mit dem passenden Kodierelement montiert werden kann, und zwar an einer vorbestimmten Position und mit einer vorbestimmten Ausrichtung. Die Montage einer falschen bzw. unerwünschten Vorrichtung, oder die Montage einer erwünschten Vorrichtung auf eine unerwünschte Weise, kann somit praktisch vollständig vermieden werden.

Die Tatsache, dass der Kodierabschnitt (mit dem Kodierelement) an dem Linsenelement und nicht etwa an einer anderen Komponente der Vorrichtung ausgebildet ist, bietet Vorteile insbesondere im Hinblick auf eine auf dem geschilderten Poka-Yoke-Prinzip beruhende Montage der Vorrichtung. Das Linsenelement stellt nämlich regelmäßig diejenige Komponente der Vorrichtung dar, dessen Positionierung besonders genau erfolgen muss, um im Rahmen der vorgesehenen Anwendung (z.B. Messen einer Distanz) eine einwandfreie Funktionsweise der Vorrichtung zu gewährleisten. Das Linsenelement muss regelmäßig besonders genau positioniert werden, um die gewünschten optischen Eigenschaften der Vorrichtung (z.B. Fokussierung eines einfallenden optischen Signals auf einen optoelektronischen Empfänger) zu realisieren. Um eine genaue Positionierung der optoelektronischen Vorrichtung zu gewährleisten, kann ein in der Montageumgebung der Vorrichtung vorgesehenes Dekodierelement verwendet werden, welches z.B. die genaue Ausrichtung des Linsenelements relativ zu einem erwünschten Detektionsbereich sicherstellt, wenn die Vorrichtung korrekt montiert ist. Beispielsweise kann ein Dekodierelement das Linsenelement über den Kodierabschnitt abstützen. Ein weiterer Grund, warum die Anbringung des Kodierabschnitts an dem Linsenelement besonders vorteilhaft ist, besteht darin, dass das Linsenelement typischerweise ein Bauelement der optoelektronischen Vorrichtung mit besonders geringen Fertigungstoleranzen ist.

Die optoelektronische Vorrichtung zeichnet sich durch einen modularen Aufbau aus, bei dem die Vorrichtung nach Art eines Baukastensystems aus verschiedenen separaten Komponenten zusammengesetzt ist. Diese separaten Komponenten umfassen zumindest die Trägereinrichtung, das Linsenelement und die Halteeinrichtung. Optional können weitere optisch wirksame Komponenten vorgesehen sein, z.B. ein Aperturelement und/oder ein Filterelement. Die einzelnen Komponenten werden vorzugsweise lösbar miteinander verbunden oder aneinandergehalten. Insbesondere können die Komponenten kraftschlüssig und/oder formschlüssig aneinander gehalten sein. Die Komponenten können entlang der genannten Vertikalrichtung im Wesentlichen hintereinander angeordnet sein (z.B. in einer Schichtanordnung bzw. Sandwich-Struktur). Hierdurch können verschiedene Varianten der Trägereinrichtung und des Linsenelements sowie optionale Komponenten auf einfache Weise auf Basis einer universellen Modulplattform miteinander kombiniert werden, um unterschiedliche optoelektronische Vorrichtungen herzustellen, wobei einige Komponenten der unterschiedlichen optoelektronischen Vorrichtungen gleichartig sein können (z.B. die Halteeinrichtung).

Im Zusammenhang mit der Erfindung ist unter einem Linsenelement ein Abbildungselement zu verstehen, das insbesondere refraktive (d.h. lichtbrechende) Eigenschaften aufweisen kann. Der jeweilige Linsenabschnitt kann strahlformende Eigenschaften aufweisen, insbesondere indem der jeweilige Linsenabschnitt an einer Seite oder an zwei Seiten eine Wölbung aufweist (z.B. als Sammellinse, Zerstreungslinse oder Fresnel-Linse). Alternativ oder zusätzlich hierzu kann der jeweilige Linsenabschnitt eine Umlenkung eines Strahlbündels bewirken, d.h. eine Änderung der Ausbreitungsrichtung eines emittierten oder empfangenen Strahlbündels. Insbesondere kann der jeweilige Linsenabschnitt eine Keilform aufweisen (z.B. Ausgestaltung als Keillinse mit zwei in einem spitzen Winkel zueinander ausgerichteten Planflächen). Der jeweilige Linsenabschnitt kann parallel oder schräg zu einer Erstreckungsebene der Trägereinrichtung ausgerichtet sein. Das Linsenelement kann außerhalb des jeweiligen Linsenabschnitts plattenförmig sein. Der jeweilige Linsenabschnitt kann integral ausgebildet und/oder oberhalb des optoelektronischen Senders bzw. Empfängers angeordnet sein.

Die Trägereinrichtung der optoelektronischen Vorrichtung kann zumindest im Wesentlichen plattenförmig sein und/oder einen umspritzten Leiterrahmen umfassen. Die Trägereinrichtung kann mehrere elektrische Anschlüsse umfassen, welche mit einem ASIC (Application-Specific Integrated Circuit) der Trägereinrichtung und/oder mit dem optoelektronischen Sender oder Empfänger verbunden sein können. Die Anschlüsse der Trägereinrichtung können eine elektrische Kontaktierung von außen ermöglichen. Die Anschlüsse können insbesondere zur Anbindung der Trägereinrichtung an einen der optoelektronischen Vorrichtung zugeordneten Microcontroller vorgesehen sein, um die Vorrichtung anwendungsgemäß betreiben zu können. Die eingangs genannte Vertikalrichtung kann insbesondere senkrecht zu einer Erstreckungsebene der Trägereinrichtung verlaufen.

Das Linsenelement kann insbesondere zumindest im Wesentlichen plattenförmig sein und/oder wenigstens einen integral ausgebildeten Linsenabschnitt umfassen, der oberhalb des optoelektronischen Senders bzw. Empfängers angeordnet ist.

Die Halteeinrichtung dient dazu, zumindest die Trägereinrichtung und das Linsenelement relativ zueinander zu halten, wobei eine Ausrichtung des Linsenelements bezüglich der Trägereinrichtung eingehalten wird, die mit dem wenigstens einen optoelektronischen Sender und/oder Empfänger bestückt ist. Hierbei kann die Halteeinrichtung das Linsenelement direkt oder indirekt an der Trägereinrichtung sichern und/oder fixieren. Die Halteeinrichtung kann hierfür beispielsweise eine Klammer oder wenigstens ein klammerartiges Element aufweisen, welches zumindest die Trägereinrichtung und das Linsenelement umgreift oder hintergreift. Zusätzlich oder alternativ kann die Halteeinrichtung gehäuseartig oder käfigartig ausgebildet sein, wobei eine solche Halteeinrichtung die Trägereinrichtung und das Linsenelement nicht vollständig umschließen muss, insbesondere nicht vollflächig und auch nicht an jeder Seite der Vorrichtung. Die Halteeinrichtung kann somit zumindest funktional als Gehäuse der Vorrichtung dienen oder sogar ein echtes, zumindest überwiegend geschlossenes Gehäuse sein, wobei zumindest eine mechanische Kapselung der Komponenten der Vorrichtung sichergestellt wird.

Die Halteeinrichtung kann insbesondere eine Basisplatte mit mehreren Seitenwänden und/oder mit mehreren, insbesondere zwei, vier oder sechs paarweise einander gegenüberliegenden, Haltearmen oder Halteabschnitten aufweisen. Die Basisplatte kann eine einheitliche Plattengröße besitzen, die z.B. an die Form und Größe der Trägereinrichtung und/oder des Linsenelements angepasst ist. Hierdurch kann die Vorrichtung robust und kompakt ausgebildet werden, wobei ein Anhaften oder Eindringen von Schmutz und dergleichen an bzw. in die Vorrichtung vermieden wird. Vorzugsweise ist die Basisplatte an einer Unterseite der Trägereinrichtung angeordnet und bildet einen Bodenabschnitt. Die Halteeinrichtung kann einen zumindest abschnittsweise stufenförmigen und/oder U-förmigen Querschnitt und/oder mehrere Öffnungen aufweisen, sodass eine in die Halteeinrichtung eingelegte Komponente der Vorrichtung, welche zumindest abschnittsweise komplementär zu der Halteeinrichtung ausgebildet ist, in der Halteeinrichtung seitlich und/oder in Vertikalrichtung gefangen ist, ohne dass es hierfür gesonderter Befestigungsmittel bedarf. Die Halteeinrichtung kann ferner einteilig oder mehrteilig, insbesondere zweiteilig, ausgebildet sein.

Der modulare Aufbau der Vorrichtung ist einerseits vorteilhaft, um eine Vielzahl unterschiedlicher Vorrichtungstypen mit im Wesentlichen einheitlichen, nur geringfügig unterschiedlichen Komponenten kostengünstig herstellen zu können. Andererseits ist es jedoch denkbar, dass durch eine Verwendung einheitlicher Komponenten ein insgesamt einheitliches Erscheinungsbild der Vorrichtungen hervorgerufen wird, was die Verwechslungsgefahr zwischen unterschiedlichen Vorrichtungstypen prinzipiell erhöhen könnte. Eine Erhöhung der Verwechslungsgefahr wird bei der erfindungsgemäßen Vorrichtung jedoch durch den individuellen Kodierabschnitt des Linsenelements vermieden. Dieser kann unabhängig von einem jeweiligen Vorrichtungstyp stets in einem bestimmten Bereich der Vorrichtung ausgebildet sein, um diesbezüglich eine einheitliche Kennzeichnungsweise der Vorrichtungen und somit eine verringerte Verwechslungsgefahr zu bewerkstelligen.

Gemäß einer vorteilhaften Ausführungsform kann der mechanische Kodierabschnitt in einer seitlichen Richtung, d.h. quer zu der genannten Vertikalrichtung, aus der Halteeinrichtung herausragen.

Die optoelektronische Vorrichtung weist vorzugsweise eine im Querschnitt zumindest im Wesentlichen rechteckige Form auf, wobei der mechanische Kodierabschnitt an einer Schmalseite der rechteckigen Form aus der Halteeinrichtung herausragt. Vorzugsweise erstreckt sich der Kodierabschnitt parallel zu einer Längsachse der Vorrichtung und bildet diesbezüglich einen sich in Längsrichtung erstreckenden Fortsatz der Vorrichtung, der sich auf eine charakteristische Weise von der Vorrichtung abheben kann. Die Anordnung des Kodierabschnitts an der Schmalseite besitzt den Vorteil, dass die rechteckige und vorzugsweise schlanke Form der Vorrichtung trotz des Kodierabschnitts erhalten bleibt und die Vorrichtung bei der Montage manuell gut in der Hand liegt, sofern eine manuelle Montage vorgesehen ist. Der Kodierabschnitt ist hierbei im Vergleich zu einer mittigen oder zentralen Positionierung des Kodierabschnitts im Zweifel besser ersichtlich und insbesondere optisch detektierbar (z.B. während eines maschinellen Montageprozesses). Ferner besitzt eine rechteckige Form der Vorrichtung in vielen Anwendungsfällen Vorteile gegenüber anderen Formen, beispielsweise im Hinblick auf die Bereitstellung einer geeigneten Montageumgebung für die Vorrichtung.

Im Hinblick auf den geschilderten Formschluss mit der Montageumgebung nach dem mechanischen Poka-Yoke-Prinzip ist es bevorzugt, wenn eine Identifizierungsinformation des jeweiligen Kodierelements des Kodierabschnitts entlang der genannten Vertikalrichtung der optoelektronischen Vorrichtung erfassbar ist. Somit kann die Vorrichtung mit der Unterseite voraus oder mit der Oberseite voraus an der Montageumgebung montiert werden, und die Identifizierungsinformation des jeweiligen Kodierelements kann unmittelbar mechanisch abgetastet werden. Als Unterseite der optoelektronischen Vorrichtung ist im Zusammenhang mit der Erfindung diejenige Seite anzusehen, die aus der Sicht der Trägereinrichtung dem optoelektronischen Sender und/oder Empfänger abgewandt ist. Als Oberseite der optoelektronischen Vorrichtung ist dementsprechend diejenige Seite anzusehen, in deren Richtung der an der Trägereinrichtung montierte optoelektronische Sender und/oder Empfänger ausgerichtet ist.

Gemäß einer bevorzugten Ausführungsform weist das wenigstens eine Kodierelement wenigstens eine Erhebung und/oder wenigstens eine Vertiefung des mechanischen Kodierabschnitts auf. Die Erhebung und/oder Vertiefung kann insbesondere gegenüber einer rotationssymmetrischen Struktur oder gegenüber einer planen Fläche gebildet sein. Ein derartiges Kodierelement kann auf einfache Weise hergestellt werden, beispielsweise mittels einer Gussform für das Linsenelement, welche abschnittsweise komplementär zu der gewünschten Form des Kodierelements ausgebildet ist. Ferner sind zur Umsetzung des geschilderten Poka-Yoke-Prinzips sowohl eine Erhebung als auch eine Vertiefung besonders geeignet. Ein Kodierelement kann für die individuelle Identifizierung der optoelektronischen Vorrichtung eine vorbestimmte Form und/oder eine vorbestimmte Größe und/oder eine vorbestimmte Position aufweisen.

Gemäß einer weiteren bevorzugten Ausführungsform weist der mechanische Kodierabschnitt eine ringförmige Struktur auf. Diese hebt sich besonders charakteristisch von der ansonsten insbesondere rechteckförmig ausgebildeten Vorrichtung ab und lenkt die Aufmerksamkeit zumindest indirekt auf das wenigstens eine Kodierelement, welches insbesondere an einem Außenumfang und/oder an einem Innenumfang und/oder an einer Stirnseite der ringförmigen Struktur vorgesehen sein kann. Die ringförmige Struktur besitzt hierbei den Vorteil, dass das Kodierelement z.B. lediglich in Abhängigkeit eines Winkels um eine Achse oder einen Mittelpunkt der ringförmigen Struktur an einem Umfang der ringförmigen Struktur ausgebildet werden kann. So können nahezu beliebig viele und einheitlich parametrierte Positionen für ein jeweiliges Kodierelement entlang eines Umfangs vorgesehen werden, wobei der Bereich für ein jeweiliges Kodierelement dennoch einheitlich und räumlich begrenzt festgelegt ist, um eine schnelle und sichere Identifizierung der Vorrichtung zu ermöglichen. Auf diese Weise kann ein jeweiliges Kodierelement auch vorteilhaft mittels eines einzigen und vorzugsweise leicht konfigurierbaren Werkzeugs (insbesondere eines Spritzgießwerkzeugs) an dem Kodierabschnitt ausgebildet werden, wobei z.B. lediglich die Winkelstellung einer Drehbuchse eingestellt zu werden braucht. Eine ringförmige Struktur kann im Übrigen auch dazu verwendet werden, die Vorrichtung mittels einer Schraube an der vorgesehenen Montageumgebung zu befestigen, welche durch eine zentrale Öffnung der ringförmigen Struktur geführt wird, sodass die Vorrichtung auch bei mechanischer Beanspruchung, insbesondere aufgrund von Vibrationen, sicher montiert ist.

Gemäß einer weiteren bevorzugten Ausführungsform weist der mechanische Kodierabschnitt ein erstes Kodierelement und ein zweites Kodierelement auf, wobei das erste Kodierelement an einem Außenumfang und das zweite Kodierelement an einem Innenumfang der ringförmigen Struktur vorgesehen ist. Auf diese Weise kann beispielsweise das erste Kodierelement den Vorrichtungstyp ("product ID") und das zweite Kodierelement eine Adresse oder ein Adressformat eines zur Ansteuerung der Vorrichtung vorgesehenen Bustyps (z.B. I²C Bus) identifizieren ("I²C ADR ID"). Die beiden Kodierelemente können zur Erhöhung ihrer individuellen Identifizierungskraft unterschiedlich ausgebildet sein. Beispielsweise kann sich die Form eines ersten Kodierelements charakteristisch von der Form eines zweiten Kodierelements unterscheiden. Zur Unterscheidung von mehreren ersten Kodierelementen, welche jeweils eine zugeordnete Vorrichtung identifizieren sollen, können sich die ersten Kodierelemente bezüglich ihrer Größe und/oder Position unterscheiden. Selbiges kann für die Unterscheidbarkeit mehrerer zweiter Kodierelemente vorgesehen werden. Für beide Kodierelemente (erste und zweite) kann in Anwendung des Poka-Yoke-Prinzips an einer vorgesehenen Montageumgebung auch jeweils ein komplementäres Dekodierelement vorgesehen sein, wodurch das Risiko der Montage einer unerwünschten Vorrichtung bzw. das Risiko einer Falschmontage auf doppelte Weise ausgeschlossen wird.

Die ringförmige Struktur kann insbesondere einen Hohlzylinder umfassen. Hierbei kann sich innerhalb des Hohlzylinders in einer Ebene senkrecht zu der Längsachse des Hohlzylinders eine Ringscheibe erstrecken. Die Längsachse des Hohlzylinders verläuft vorzugsweise senkrecht zu einer Ebene des Linsenelements, d.h. die Ringscheibe erstreckt sich innerhalb oder parallel zu der Ebene des Linsenelements. Die Ringscheibe kann bezüglich der Stirnseiten des Hohlzylinders mittig angeordnet sein, sodass sich ein in Längsrichtung spiegelsymmetrischer Hohlzylinder ergibt. Somit kann die Vorrichtung zumindest unabhängig von der jeweiligen Stirnseite des Hohlzylinders montiert werden, wodurch die Vorrichtung vielseitiger verwendet und in unterschiedlichen Ausrichtungen montiert werden kann. Die Hohlzylinderstruktur zeichnet sich auch dadurch aus, dass an den Stirnseiten des Hohlzylinders jeweils eine Vertiefung gebildet ist, welche ebenfalls als Kodierelement der Vorrichtung aufgefasst und verwendet werden kann.

Gemäß einer weiteren Ausführungsform erstreckt sich der wenigstens eine Linsenabschnitt des Linsenelements innerhalb einer Linsenerstreckungsebene, wobei der mechanische Kodierabschnitt aus der Linsenerstreckungsebene herausragt. Der mechanische Kodierabschnitt kann sich insbesondere entlang der genannten Vertikalrichtung der optoelektronischen Vorrichtung erstrecken. Hierdurch kann das Linsenelement über den Kodierabschnitt im montierten Zustand der Vorrichtung besonders vorteilhaft abgestützt und exakt ausgerichtet werden. In einer bevorzugten Variante erstreckt sich der Kodierabschnitt jedoch nicht bis zu einer Oberseite und/oder Unterseite der Halteeinrichtung und/oder der Vorrichtung, sodass eine plane Anlagefläche der Halteeinrichtung bzw. der Vorrichtung nicht gleichzeitig eine Anlagefläche für den Kodierabschnitt bildet. Überbestimmungen bzw. mechanische Verspannungen zwischen dem Linsenelement und den anderen Komponenten der Vorrichtung können hierdurch effektiv vermieden werden.

Die Halteeinrichtung und das Linsenelement können direkt oder indirekt mittels eines Rastschlusses aneinander gesichert sein. Hierdurch können die beiden Teile sicher aber dennoch lösbar miteinander verbunden werden. Insbesondere bei gehäuse- oder käfigartiger Ausbildung der Halteeinrichtung ist es zudem auch möglich, dass das Linsenelement zwischen der Halteeinrichtung und der Trägereinrichtung gefangen ist.

Nach einer weiteren Ausführungsform weist die optoelektronische Vorrichtung ferner wenigstens ein Aperturelement auf, das wenigstens einen Aperturabschnitt für den wenigstens einen optoelektronischen Sender und/oder den wenigstens einen optoelektronischen Empfänger aufweist. Durch den jeweiligen Aperturabschnitt können eine Querschnittsausdehnung und/oder ein Winkelbereich der Strahlen festgelegt werden. Das Aperturelement kann insbesondere plattenförmig sein, wobei die Plattengröße und/oder die Plattenform einer einheitlichen Plattengröße und/oder Plattenform zumindest einiger der Komponenten der Vorrichtung entsprechen kann. Der jeweilige Aperturabschnitt kann durch eine Öffnung des Aperturelements gebildet sein, die vorzugsweise kreisrund ist und bezüglich einer Sendeachse bzw. Empfangsachse des optoelektronischen Senders oder Empfängers koaxial ausgerichtet oder versetzt ist. Durch die Anordnung und Formgebung des jeweiligen Aperturabschnitts können optische Eigenschaften der optoelektronischen Vorrichtung festgelegt und unerwünschte Störeinflüsse (z.B. aufgrund interner oder äußerer Reflexionen) unterdrückt werden. Durch unterschiedliche auswählbare Aperturelemente wird die Modularität des geschilderten Baukastensystems noch weiter erhöht.

Das Aperturelement kann zwischen der Trägereinrichtung und dem Linsenelement angeordnet sein. Hierbei ist es denkbar, dass das Aperturelement zwischen der Trägereinrichtung und dem Linsenelement in Vertikalrichtung gefangen ist, d.h. das Aperturelement ist indirekt an der Vorrichtung befestigt, sodass keine eigenständige Befestigung des Aperturelements notwendig ist und die Komponenten der Vorrichtung einfach mit unterschiedlichen Aperturelementen kombiniert werden können. Hierfür kann das Aperturelement zumindest abschnittsweise (z.B. an dem Umfang) komplementär zu der Halteeinrichtung ausgebildet sein.

Alternativ oder zusätzlich zu dem Aperturelement kann die optoelektronische Vorrichtung weitere Komponenten aufweisen, wie beispielsweise ein Filterelement für ein spektrales Filtern von emittierter oder empfangener Strahlung.

Die Halteeinrichtung kann insbesondere einteilig ausgebildet sein, wobei die Halteeinrichtung einseitig, insbesondere an der Oberseite der Vorrichtung, offen und dort z.B. durch das Linsenelement oder durch das Aperturelement verschlossen sein kann.

Gemäß einer weiteren Ausführungsform ist die Halteeinrichtung zweiteilig ausgebildet, wobei die Halteeinrichtung ein Unterteil sowie ein Oberteil aufweist. Das Unterteil und das Oberteil können hierbei insbesondere lösbar aneinander gesichert sein, wobei das Unterteil und/oder das Oberteil das Linsenelement, die Trägereinrichtung sowie gegebenenfalls das Aperturelement und weitere optionale Komponenten der Vorrichtung umgreifen oder hintergreifen können. Das Unterteil der Halteeinrichtung kann einen Bodenabschnitt und mehrere hiervon nach oben abkragende Verbindungsabschnitte aufweisen. Ferner kann das Oberteil der Halteeinrichtung einen Deckelabschnitt und mehrere hiervon nach unten abkragende Verbindungsabschnitte aufweisen, die mit den Verbindungsabschnitten des Unterteils zusammenwirken. Das Unterteil und/oder das Oberteil können einen im Wesentlichen U-förmigen Querschnitt aufweisen, um einen Aufnahmeraum zumindest für die Trägereinrichtung und das Linsenelement zu bilden, welcher die Herstellung der Vorrichtung vereinfacht.

Die Trägereinrichtung und das Linsenelement können zwischen dem Unterteil und dem Oberteil der Halteeinrichtung angeordnet und insbesondere zwischen dem Unterteil und dem Oberteil der Halteeinrichtung in Vertikalrichtung gefangen sein. Die Vorrichtung kann somit besonders effizient zusammengesetzt werden, da die Trägereinrichtung, das Linsenelement sowie optionale Komponenten nicht gesondert befestigt werden müssen. Beispielsweise können die Trägereinrichtung und das Linsenelement in das Unterteil eingelegt werden, wobei das Unterteil danach mit dem Oberteil verschlossen wird, und wobei das Linsenelement hierdurch automatisch an der Trägereinrichtung fixiert ist.

Das Unterteil und das Oberteil der Halteeinrichtung können insbesondere mittels eines Rastschlusses aneinander befestigt sein.

Das Oberteil der Halteeinrichtung kann wenigstens einen Aperturabschnitt für den wenigstens einen optoelektronischen Sender und/oder den wenigstens einen optoelektronischen Empfänger aufweisen. Der wenigstens eine Aperturabschnitt des Oberteils der Halteeinrichtung kann zusätzlich oder alternativ zu dem genannten Aperturelement vorgesehen sein. Hierdurch ergeben sich zusätzliche Variations- und Anpassungsmöglichkeiten, um einen gewünschten Vorrichtungstyp auf möglichst einfache Weise effizient herstellen zu können, wobei dennoch eine optimale Einstellung der optischen Eigenschaften erzielbar ist.

Vorzugsweise ist innerhalb des Systems wenigstens eine Komponente der verschiedenen optoelektronischen Vorrichtungen identisch ausgebildet, insbesondere die Halteeinrichtung und/oder die Trägereinrichtung (abgesehen von den hieran vorgesehenen optoelekronischen oder elektronischen Elementen, wie Sender, Empfänger und ASIC).

Die Erfindung wird nachfolgend rein beispielhaft anhand der Zeichnungen beschrieben, in denen:
- Fig. 1: eine Explosionsdarstellung einer ersten Ausführungsform einer optoelektronischen Vorrichtung ist;
- Fig. 2: eine Perspektivansicht von Komponenten der Vorrichtung von Fig. 1 ist;
- Fig. 3: eine Perspektivansicht der Vorrichtung von Fig. 1 in einem zusammengesetzten Zustand ist;
- Fig. 4: eine Draufsicht von oben auf vier Ausführungsformen eines Linsenelements für die Vorrichtung von Fig. 1 ist;
- Fig. 5: zwei Perspektivansichten eines Montageorts für eine Vorrichtung gemäß Fig. 1, (a) ohne montierte Vorrichtung und (b) mit montierter Vorrichtung, umfasst;
- Fig. 6: zwei Perspektivansichten eines weiteren Montageorts für eine Vorrichtung gemäß Fig. 1, (a) ohne montierte Vorrichtung und (b) mit montierter Vorrichtung, umfasst;
- Fig. 7: eine Draufsicht von oben, eine Seitenansicht sowie eine Rückansicht einer zweiten Ausführungsform einer optoelektronischen Vorrichtung umfasst.

In den Zeichnungen sind gleiche oder gleichartige Elemente mit den gleichen Bezugszeichen gekennzeichnet.

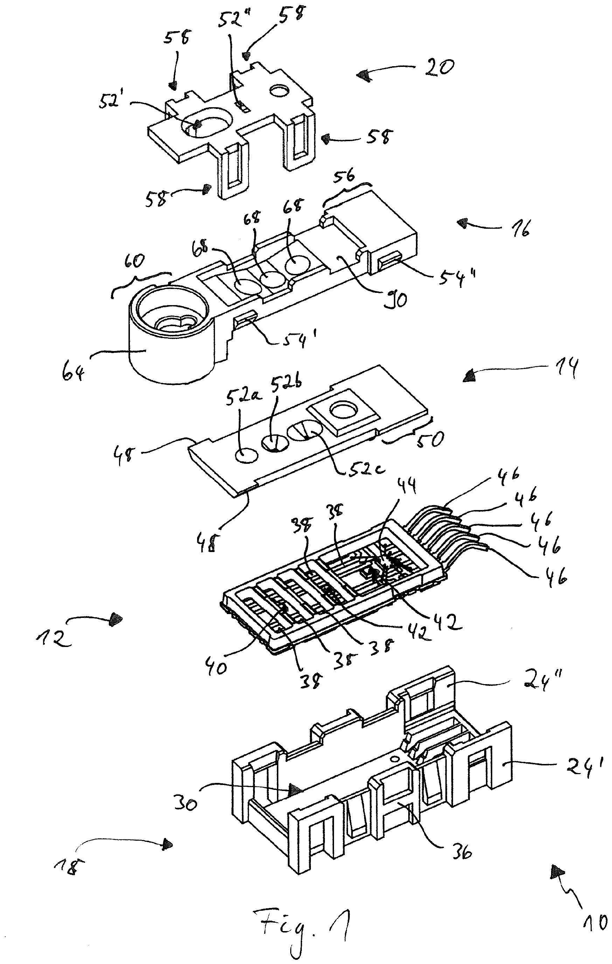

Eine optoelektronische Vorrichtung 10 umfasst eine Trägereinrichtung 12, ein optionales Aperturelement 14, ein Linsenelement 16 sowie eine ein Unterteil 18 sowie ein Oberteil 20 umfassende Halteeinrichtung. Sämtliche dieser Komponenten sind in Fig. 1 von schräg oben gezeigt, d.h. die Perspektive ist schräg auf eine jeweilige Oberseite der Komponenten gerichtet.

Nachfolgend wird beschrieben, wie die Vorrichtung 10 zusammengesetzt wird, wobei die einzelnen Komponenten der optoelektronischen Vorrichtung 10 genauer erläutert werden.

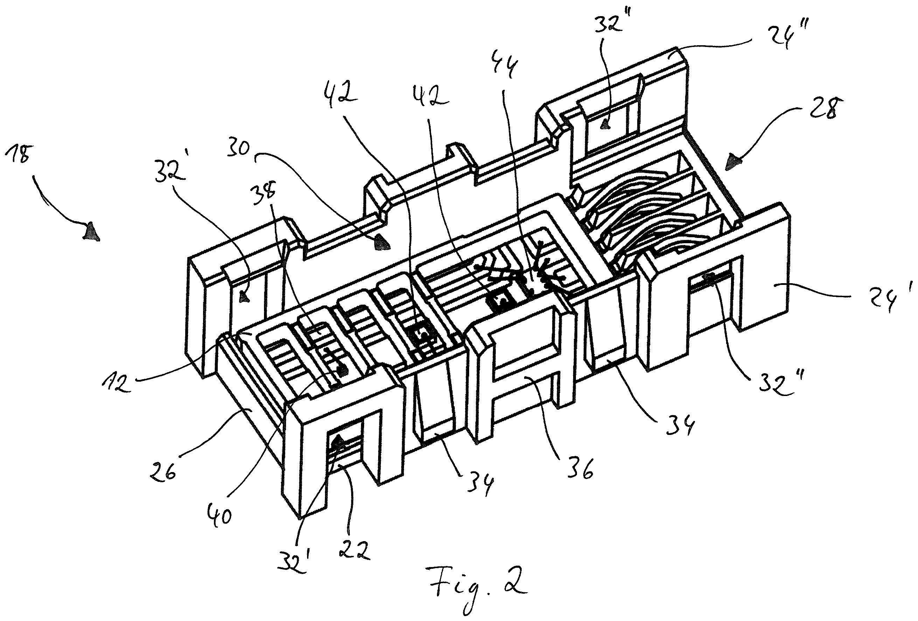

Zunächst wird die Trägereinrichtung 12 in das Unterteil 18 eingelegt. Das Unterteil 18 mit eingelegter Trägereinrichtung 12 ist in Fig. 2 dargestellt, wobei der Maßstab in Fig. 2 gegenüber Fig. 1 vergrößert ist. Das Unterteil 18 weist einen Bodenabschnitt 22 mit mehreren hiervon nach oben abkragenden Verbindungsabschnitten auf. Im Einzelnen erstrecken sich zwei bezüglich der Längserstreckung des Unterteils 18 spiegelsymmetrisch ausgebildete Seitenteile 24', 24" nach oben weg von dem Bodenabschnitt 22, wobei die Seitenteile 24', 24" im Wesentlichen senkrecht zu dem Bodenabschnitt 22 ausgerichtet sind. Ferner weist der Bodenabschnitt 22 einen stirnseitigen Riegel 26 sowie einen Kammabschnitt 28 auf. Das auf diese Weise U-förmig ausgebildete Unterteil 18 weist einen nach oben vollständig und seitlich teilweise geöffneten Aufnahmeraum 30 zur Aufnahme der Trägereinrichtung 12, des Aperturelements 14 und des Linsenelements 16 auf. Die Größe und Form des Aufnahmeraums 30 entsprechen abschnittsweise im Wesentlichen der Größe und Form der Trägereinrichtung 12, des Aperturelements 14 und des Linsenelements 16. Die Komponenten 12, 14 und 16 können somit passgenau in das Unterteil 18 eingesetzt werden.

Die Seitenteile 24', 24" weisen jeweils zwei rechteckförmige Öffnungen 32' und 32" sowie zwei voneinander beabstandete, außenseitige Rastnasen 34 auf. Ferner weisen die Seitenteile 24', 24" jeweils einen zentral angeordneten, außenseitigen Rastriegel 36 auf. Der Aufnahmeraum 30 ist im Bereich des Kammabschnitts 28 gegenüber dem mittigen Bereich verbreitert.

Die Trägereinrichtung 12 ist als umspritzter Leiterrahmen ausgebildet (sogenannter "pre-molded leadframe"), der variabel bestückbar ist. Der Umfang der Trägereinrichtung 12 ist komplementär zu dem Aufnahmeraum 30 des Unterteils 18 ausgebildet, so dass die Trägereinrichtung 12 wie in Fig. 2 dargestellt in das Unterteil 18 eingelegt werden kann, wobei die Trägereinrichtung 12 in der Ebene des Bodenabschnitts 22 zwischen dem Riegel 26, dem Kammabschnitt 28 sowie den Seitenteilen 24', 24" seitlich gefangen ist. Die Oberseite der Trägereinrichtung 12 ist in Längsrichtung in mehrere Kammern 38 eingeteilt, wobei grundsätzlich in jeder Kammer 38 ein optoelektronischer Sender oder ein optoelektronischer Empfänger angebracht und elektrisch kontaktiert werden kann. Die in Fig. 1 dargestellte Trägereinrichtung 12 weist einen optoelektronischen Sender 40, zwei optoelektronische Empfänger 42 sowie einen ASIC 44 (Application-Specific-Integrated-Circuit) auf. Zur Anbindung der Trägereinrichtung 12 an einen externen Microcontroller (nicht gezeigt) sind mehrere elektrische Anschlüsse 46 vorgesehen, welche sich an einer Schmalseite der Trägereinrichtung 12 in einer einheitlichen Bogenform von der Trägereinrichtung 12 wegerstrecken. Wenn die Trägereinrichtung 12 in das Unterteil 18 eingelegt ist, greifen die Anschlüsse 46 rückfedernd in den Kammabschnitt 28 des Unterteils 18 ein, wodurch eine Kontaktierungszone für das Einführen eines elektrischen Steckverbinders (nicht gezeigt) gebildet ist (Fig. 2).

Nachdem die Trägereinrichtung 12 in das Unterteil 18 eingelegt wurde, wird das Aperturelement 14 in den Aufnahmeraum 30 des Unterteils 18 eingelegt (nicht gezeigt). Hierbei greift ein jeweiliger seitlicher Vorsprung 48 des Aperturelements 14 in eine jeweilige Öffnung 32', 32" der Seitenteile 24', 24" ein (Fig. 1 und Fig. 2). Ferner greift ein verbreiterter Bereich 50 des Aperturelements 14 in den im Bereich des Kammabschnitts 28 verbreiterten Aufnahmeraum 30 ein. Auf diese Weise ist das Aperturelement 14 insbesondere in Längsrichtung der Vorrichtung 10 nicht verschiebbar und diesbezüglich an dem Unterteil 18 gesichert. Das Aperturelement 14 in Fig. 1 weist ferner drei unterschiedlich ausgebildete Aperturabschnitte 52a, 52b und 52c auf, welche in Längsrichtung hintereinander an dem Aperturelement 14 angeordnet sind und durch im Wesentlichen kegelstumpfförmig umrandete Öffnungen gebildet sind.

Als nächstes wird das Linsenelement 16 in den Aufnahmeraum 30 des Unterteils 18 eingelegt, wobei jeweils ein seitlicher Vorsprung 54', 54" in eine jeweilige Öffnung 32', 32" der Seitenteile 24', 24" eingreift. Ferner greift ein verbreiterter Bereich 56 des Linsenelements 16 in den im Bereich des Kammabschnitts 28 verbreiterten Bereich des Aufnahmeraums 30 ein. Das Linsenelement 16 ist auf diese Weise in Längs- und Querrichtung in einer Ebene parallel zu dem Bodenabschnitt 22 an dem Unterteil 18 fixiert.

Abschließend wird das Oberteil 20 der Halteeinrichtung mittels Rastschluss an dem Unterteil 18 befestigt, wobei das Oberteil 20 hierfür vier nach unten abkragende Rastlaschen 58 aufweist, welche jeweils mit einer der Rastnasen 34 der Seitenteile 24', 24" verrasten. Die Trägereinrichtung 12, das Aperturelement 14 und das Linsenelement 16 sind nun zwischen dem Oberteil 20 und dem Unterteil 18 vollständig gefangen und aneinander fixiert. Das Unterteil 18 der Halteeinrichtung, die Trägereinrichtung 12, das Aperturelement 14, das Linsenelement 16 und das Oberteil 20 der Halteeinrichtung sind somit entlang einer Vertikalrichtung hintereinander angeordnet.

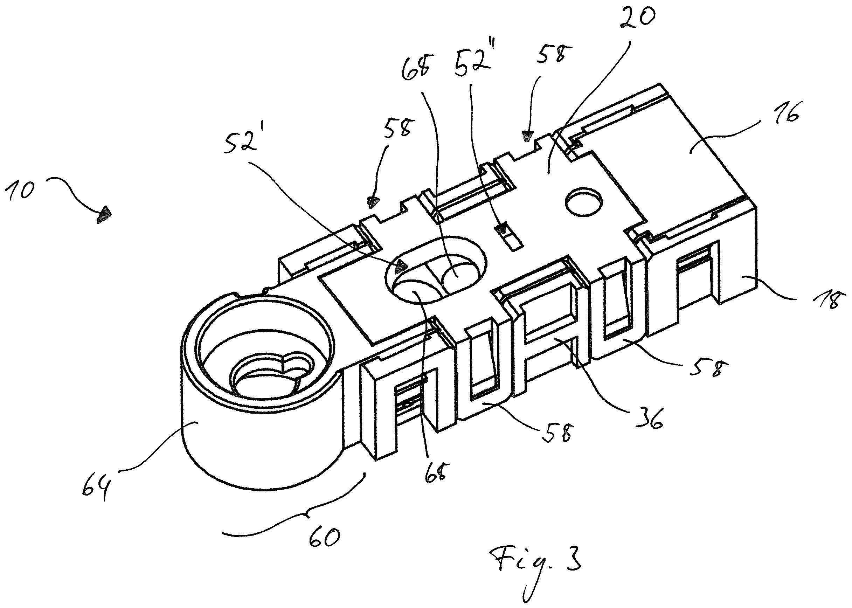

Die derart zusammengesetzte Vorrichtung 10 ist in Fig. 3 perspektivisch dargestellt. Das Oberteil 20 weist zwei Aperturabschnitte 52', 52" auf und dient somit zugleich als ein weiteres Aperturelement (vgl. Fig. 1 und Fig. 3). Ferner ist erkennbar, dass das Oberteil 20 in einen komplementären Eingriffsabschnitt 90 des Linsenelements 16 (vgl. Fig. 1) eingreift, sodass das Oberteil 20 bündig mit dem Linsenelement 16 abschließt und eine im Wesentlichen glatte Oberseite der Vorrichtung 10 gebildet ist. Darüber hinaus wird das Linsenelement 16 zusätzlich fixiert und die Größe der Vorrichtung 10 klein gehalten.

Durch die drei Aperturabschnitte 52a, 52b und 52c des Aperturelements 14 in Kombination mit den zwei Aperturabschnitten 52', 52" des Oberteils 20 werden die optischen Eigenschaften der optoelektronischen Vorrichtung 10 festgelegt und unerwünschte Störeinflüsse unterdrückt, indem eine geometrische Begrenzung des jeweiligen Querschnitts der emittierten oder empfangenen Strahlenbündel erfolgt.

Die Vorrichtung 10 besitzt einen schlanken, im Wesentlichen quaderförmigen Grundkörper, wobei die Außenhaut der Vorrichtung sich durch im Wesentlichen bündig miteinander abschließende Flächen auszeichnet. Insbesondere schließen die Rastlaschen 58 bündig mit der Außenseite der Seitenteile 24', 24" ab.

Das im Wesentlichen plattenförmige Linsenelement 16 weist einen integral ausgebildeten, mechanischen Kodierabschnitt 60 auf, welcher sich in Längsrichtung von dem ansonsten plattenförmig ausgebildeten Linsenelement 16 weg erstreckt (Fig. 1). Der ringförmig ausgebildete Kodierabschnitt 60 weist einen Hohlzylinder 64 auf, welcher senkrecht von einer Erstreckungsebene von drei in Längsrichtung hintereinander angeordneten Linsenabschnitten 68 des Linsenelements 16 abkragt. Die Linsenabschnitte 68 des Linsenelements 16 weisen strahlformende Eigenschaften auf und können beispielsweise Konvex-Linsen, Bikonvex-Linsen oder Fresnel-Linsen umfassen.

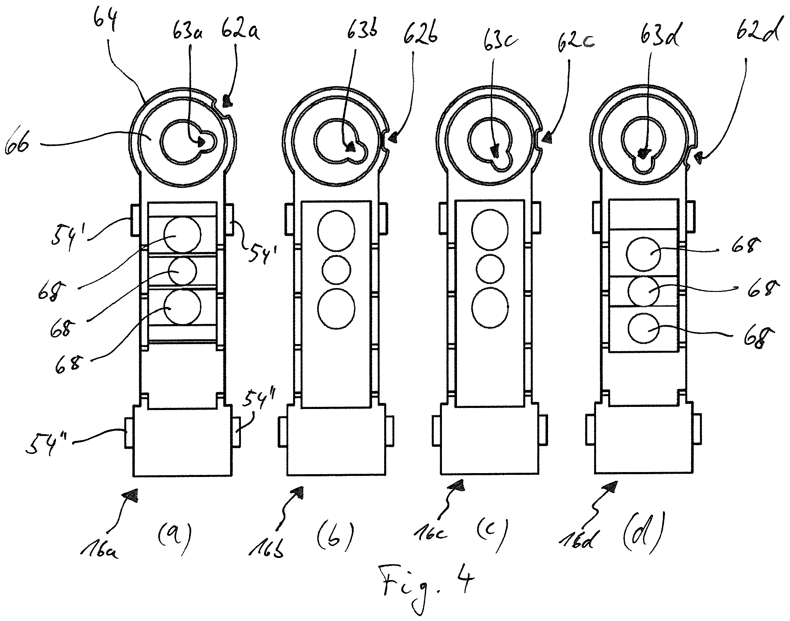

Weitere Details zu dem Linsenelement 16 sind in Fig. 4 (a) bis (d) gezeigt, in der vier verschiedene Varianten des Linsenelements 16 in einer jeweiligen Draufsicht auf die jeweilige Oberseite des Linsenelements 16 dargestellt sind. Die in Fig. 4 (a) bis (d) gezeigten Linsenelemente 16a, 16b 16c und 16d weisen an dem Kodierabschnitt 60 ein jeweiliges erstes Kodierelement 62a bis 62d und ein jeweiliges zweites Kodierelement 63a bis 63d auf. Das jeweilige erste Kodierelement 62 ist als rechteckförmige Vertiefung an dem Außenumfang des Hohlzylinders 64 des Kodierabschnitts 60 ausgebildet, wobei die Kodierelemente 62a bis 62d sich lediglich bezüglich der Winkelstellung um die Achse des Hohlzylinders 64 unterscheiden. Das jeweilige erste Kodierelement 62 erstreckt sich parallel zu der Zylinderachse (in Fig. 4 senkrecht zur Papierebene), sodass sich eine rechteckförmige Nut in dem Zylindermantel des Hohlzylinders 64 ergibt. Innerhalb des Hohlzylinders 64 erstreckt senkrecht zu dessen Längsachse eine Ringscheibe 66. An dem Innenumfang der Ringscheibe 66 ist das jeweilige zweite Kodierelement 63 vorgesehen, welches als im Wesentlichen halbkreisförmige Vertiefung ausgebildet ist und sich in unterschiedlichen Winkelstellungen um die Achse des Hohlzylinders 64 parallel zu der Zylinderachse als Rundnut erstreckt.

Die ersten Kodierelemente 62 sind lediglich beispielhaft dafür vorgesehen, die zugrundeliegende Vorrichtung 10 bezüglich eines Vorrichtungstyps zu identifizieren. Ein Vorrichtungstyp ist insbesondere durch die jeweilige Ausbildung des Linsenelements 16 und durch die Bestückung der Trägereinrichtung 12 mit optoelektronischen Sendern 40 bzw. Empfängern 42 charakterisiert. Hierbei können sich insbesondere die Position und die Ausbildung von Linsenabschnitten 68 der Linsenelemente 16 unterscheiden, wie dies in Fig. 4 (a) bis (d) anhand der Linsenelemente 16a bis 16d beispielhaft gezeigt ist. Die zweiten Kodierelemente 63 sind dafür vorgesehen, die Vorrichtung 10 bezüglich eines Bus zu identifizieren, der zur Anbindung der Trägereinrichtung 12 an einen Microcontroller vorgesehen ist.

Diese Aufzählung ist lediglich beispielhaft. Grundsätzlich können die Kodierelemente 62, 63 die optoelektronische Vorrichtung 10 bezüglich frei definierbarer Merkmale identifizieren. Die Kodierelemente 62, 63 sind neben ihrer Form lediglich in Abhängigkeit ihrer Winkelstellung um die Längsachse des Hohlzylinders 64 definiert. Somit können die Kodierelemente 62, 63 einfach mithilfe eines einstellbaren Werkzeugs hergestellt werden, wobei die Winkelstellung des jeweiligen Kodierelements 62, 63 eine eindeutige Identifizierung der Vorrichtung 10 bezüglich des dem jeweiligen Kodierelement 62, 63 zugeordneten Merkmals ermöglicht.

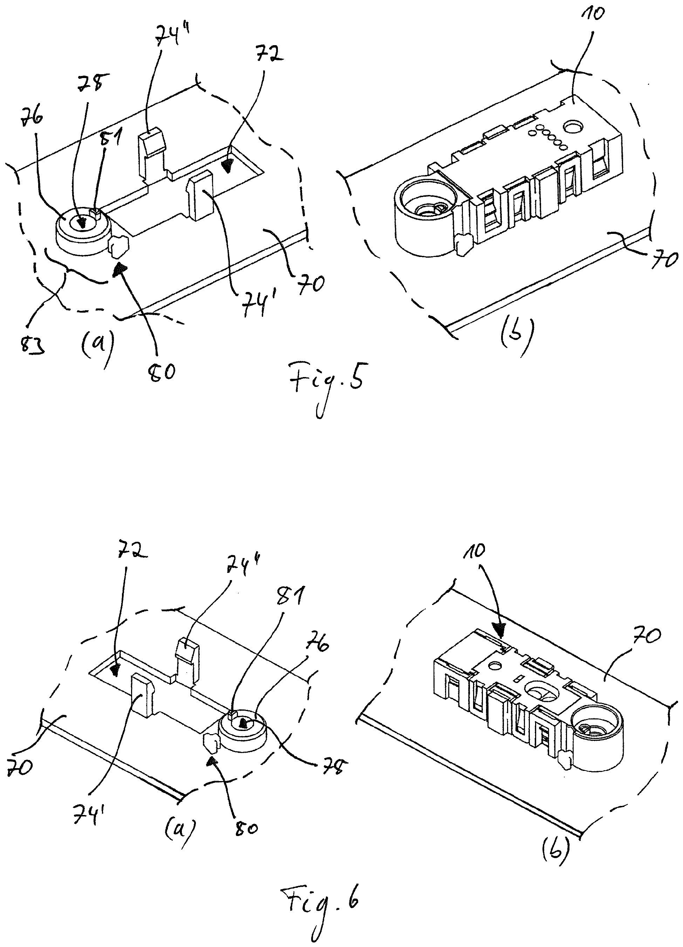

In Fig. 5 sind zwei Perspektivansichten eines Montageorts für eine optoelektronische Vorrichtung 10 gezeigt, der im Zusammenhang mit der Erfindung auch als Montageumgebung der optoelektronischen Vorrichtung 10 bezeichnet wird. In Fig. 5 (a) ist der Montageort als solcher gezeigt, d.h. ohne dass eine betreffende Vorrichtung 10 montiert ist. Der Montageort ist gekennzeichnet durch einen Abschnitt einer Grundplatte 70 mit einer rechteckförmigen Öffnung 72, an deren inneren Längskanten zwei einander gegenüberliegende Rastarme 74', 74" vorgesehen sind. Benachbart zu einer Schmalseite der Öffnung 72 ist ein Zylinder 76 ausgebildet, der sich senkrecht zu der Ebene der Grundplatte 70 erstreckt und mit einer zentralen Öffnung 78 versehen ist. Die Öffnung 78 kann ein Innengewinde für eine nicht gezeigte Schraube aufweisen.

Der Zylinder 76 weist ein erstes Dekodierelement 80 und ein zweites Dekodierelement 81 auf. Das erste Dekodierelement 80 ist T-förmig ausgebildet und von der Mantelfläche des Zylinders 76 in radialer Richtung beabstandet. Die Höhe des Dekodierelements 80 ist geringer als die Höhe des Zylinders 76. Das zweite Dekodierelement 81 ist an der Stirnseite des Zylinders 76 ausgebildet und weist abschnittsweise eine zylindrische Form auf. Der Zylinder 76 sowie die Dekodierelemente 80 und 81 bilden zusammen einen Dekodierabschnitt 83 für den Kodierabschnitt 60 einer Vorrichtung 10. Der Dekodierabschnitt 83 ist einteilig mit der Grundplatte 70 ausgebildet. Die Kanten des Zylinders 76 sowie der Dekodierelemente 80 und 81 weisen eine jeweilige Fase auf, welche die Montage der Vorrichtung 10 erleichtert.

Die an dem in Fig. 5 (a) gezeigten Montageort zu montierende Vorrichtung 10 wird mit der Oberseite der Vorrichtung 10 voraus montiert, so dass die Vorrichtung 10 die in Fig. 5 (b) dargestellte Position einnimmt, in der die Oberseite der Vorrichtung 10 der Öffnung 72 der Grundplatte 70 zugewandt ist. Durch den Dekodierabschnitt 83 ist sichergestellt, dass nur diejenige Vorrichtung 10 montiert werden kann, die einen komplementär zu dem Dekodierabschnitt 83 ausgebildeten Kodierabschnitt 60 aufweist, welcher die Montage der Vorrichtung 10 an dem betreffenden Montageort durch Formschluss eindeutig festlegt. Im montierten Zustand greift das erste Kodierelement 62 in das erste Dekodierelement 80 ein. Ferner greift das zweite Kodierelement 63 abschnittsweise in das zweite Dekodierelement 81 ein. Darüber hinaus sind die Rastarme 74', 74" mit den Rastriegeln 36 des Unterteils 18 verrastet, so dass die Vorrichtung 10 sicher an der Grundplatte 70 befestigt ist.

In Fig. 6 ist ein weiterer Montageort für eine Vorrichtung 10 gezeigt, wobei die Vorrichtung 10 im Gegensatz zu dem Fall von Fig. 5 (b) in Fig. 6 (b) umgekehrt montiert ist, d.h. die strahlungsemittierende bzw. strahlungsempfangende Oberseite der Vorrichtung 10 ist der Grundplatte 70 abgewandt. Die Vorrichtung 10 kann somit flexibel auf unterschiedliche Weise an einem im Wesentlichen gleich ausgebildeten Montageort montiert werden, wobei hierfür lediglich die Positionen der Kodierelemente 62, 63 und die Positionen der Dekodierelemente 80, 81 aufeinander abgestimmt sein müssen (vgl. Fig. 5 (a) und Fig. 6 (a)).

Vorzugsweise ist die Grundform des Kodierabschnitts 60 (insbesondere der Hohlzylinder 64 mit Ringscheibe 66) bezüglich einer Mittenebene der optoelektronischen Vorrichtung 10, die senkrecht zu der Vertikalrichtung steht, symmetrisch ausgebildet. Ferner ist es bevorzugt, wenn eine Befestigungseinrichtung zum Befestigen der optoelektronischen Vorrichtung 10 an einer Montageumgebung (insbesondere die Rastriegel 36 der Halteeinrichtung für die Rastarme 74', 74" der Grundplatte 70) bezüglich einer Mittenebene der optoelektronischen Vorrichtung 10, die senkrecht zu der Vertikalrichtung steht, symmetrisch ausgebildet ist. Hierdurch kann die Vorrichtung 10 besonders einfach wahlweise in einer von zwei verschiedenen Ausrichtungen ihrer Oberseite an der Montageumgebung befestigt werden, wie anhand der Fig. 5 und 6 erläutert wurde.

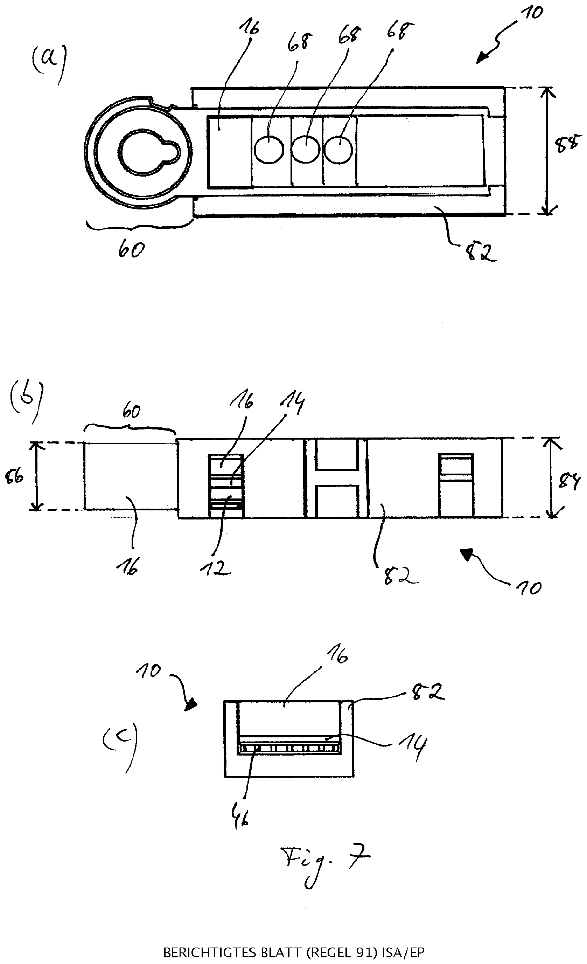

In Fig. 7 ist eine weitere Ausführungsform der optoelektronischen Vorrichtung 10 gezeigt, die sich von der in Fig. 1 - 3 gezeigten Ausführungsform insbesondere dadurch unterscheidet, dass die Vorrichtung 10 eine einteilige Halteeinrichtung 82 aufweist. Im zusammengesetzten Zustand der Vorrichtung 10 bildet hierbei das Linsenelement 16 die Oberseite der Vorrichtung 10 und ist mit der Halteeinrichtung 82 verrastet. Optional kann ein Aperturelement 14 zwischen dem Linsenelement 16 und der Trägereinrichtung 12 angeordnet, insbesondere in Vertikalrichtung gefangen sein. In Fig. 7 (a) ist die Vorrichtung 10 in einer Draufsicht von oben gezeigt. Fig. 7 (b) zeigt die Vorrichtung 10 in einer Seitenansicht, in welcher erkennbar ist, dass die Dicke 84 der Vorrichtung 10 im Bereich der Halteeinrichtung 82 größer ist als die Dicke 86 des Kodierabschnitts 60. Hierdurch können mechanische Verspannungen zwischen dem Linsenelement 16 und der Halteeinrichtung 82 vermieden werden. In Fig. 7 (c) ist die Vorrichtung 10 in einer Rückansicht gezeigt. Wie sich insbesondere aus Fig. 7 (a) und Fig. 7 (c) ergibt, ragt der Kodierabschnitt 60 lediglich in Längsrichtung aus der Halteeinrichtung 82 heraus, wobei sich der Kodierabschnitt 60 nicht jenseits der Breite 88 der Vorrichtung 10 erstreckt. Die schlanke und rechteckige Form der Vorrichtung 10 wird somit durch den Kodierabschnitt 60 nicht beeinträchtigt.

Zu den erläuterten Ausführungsbeispielen ist noch anzumerken, dass die Trägereinrichtung 12 variabel bestückt werden kann, insbesondere mit verschiedenen Anzahlen von optoelektronischen Sendern 40 und/oder optoelektronischen Empfängern 42. Durch die modulare Bauweise der jeweiligen optoelektronischen Vorrichtung 10 ist eine einfache Anpassung an unterschiedliche Anwendungen möglich, wobei durch Austauschen einzelner Komponenten (Aperturelement 14 bzw. Linsenelement 16) insbesondere auch eine der Anzahl von Sendern 40 und Empfängern 42 entsprechende Anzahl von Aperturabschnitten 52 und Linsenabschnitten 68 vorgesehen werden kann.

### Bezugszeichenliste

- 10: optoelektronische Vorrichtung
- 12: Trägereinrichtung
- 14: Aperturelement
- 16: Linsenelement
- 18: Unterteil
- 20: Oberteil
- 22: Bodenabschnitt
- 24: Seitenteil
- 26: Riegel
- 28: Kammabschnitt
- 30: Aufnahmeraum
- 32: Öffnung
- 34: Rastnasen
- 36: Rastriegel
- 38: Kammer
- 40: Sender
- 42: Empfänger
- 44: ASIC
- 46: Anschluss
- 48: Vorsprung
- 50: Bereich
- 52: Aperturabschnitt
- 54: Vorsprung
- 56: Bereich
- 58: Rastlaschen
- 60: Kodierabschnitt
- 62: erstes Kodierelement
- 63: zweites Kodierelement
- 64: Hohlzylinder
- 66: Ringscheibe
- 68: Linsenabschnitt
- 70: Grundplatte
- 72: Öffnung
- 74: Rastarm
- 76: Zylinder
- 78: Öffnung
- 80: erstes Dekodierelement
- 81: zweites Dekodierelement
- 82: Halteeinrichtung
- 83: Dekodierabschnitt
- 84: Dicke der Vorrichtung
- 86: Dicke des Kodierabschnitts
- 88: Breite der Vorrichtung
- 90: Eingriffsabschnitt

## Patentansprüche

1. System mit mehreren verschiedenen optoelektronischen Vorrichtungen (10), jeweils umfassend:
eine Trägereinrichtung (12), die an einer Oberseite wenigstens einen optoelektronischen Sender (40) und/oder wenigstens einen optoelektronischen Empfänger (42) aufweist;
ein Linsenelement (16), das bezüglich einer Vertikalrichtung oberhalb der Trägereinrichtung (12) vorgesehen ist und wenigstens einen Linsenabschnitt (68) für den wenigstens einen optoelektronischen Sender (40) und/oder den wenigstens einen optoelektronischen Empfänger (42) aufweist; und
eine Halteeinrichtung (82), die die Trägereinrichtung (12) und das Linsenelement (16) relativ zueinander hält und teilweise umgibt;
**dadurch gekennzeichnet,**
**dass** das Linsenelement (16) einen mechanischen Kodierabschnitt (60) aufweist, der aus der Halteeinrichtung (82) herausragt und der wenigstens ein Kodierelement (62, 63) zur Identifizierung der optoelektronischen Vorrichtung (10) aufweist,
wobei sich die mechanischen Kodierabschnitte (60) der Linsenelemente (16) von wenigstens einigen der verschiedenen optoelektronischen Vorrichtungen (10) bezüglich des wenigstens einen Kodierelements (62, 63) unterscheiden.

2. System nach Anspruch 1,
wobei bei jeder der mehreren verschiedenen optoelektronischen Vorrichtungen (10) das wenigstens eine Kodierelement (62, 63) wenigstens eine Erhebung und/oder wenigstens eine Vertiefung des mechanischen Kodierabschnitts (60) aufweist, wobei der mechanische Kodierabschnitt (60) eine ringförmige Struktur aufweist und das wenigstens eine Kodierelement (62, 63) an einem Außenumfang und/oder an einem Innenumfang und/oder an einer Stirnseite der ringförmigen Struktur vorgesehen ist.

3. System nach Anspruch 1 oder 2,
wobei bei jeder der mehreren verschiedenen optoelektronischen Vorrichtungen (10) der Kodierabschnitt (60) und der wenigstens eine Linsenabschnitt (68) integral mit dem Linsenelement (16) ausgebildet sind.

4. System nach zumindest einem der Ansprüche 1 bis 3,
wobei innerhalb des Systems die Halteeinrichtungen (82) und/oder die Trägereinrichtungen (12) der mehreren verschiedenen optoelektronischen Vorrichtungen (10) identisch ausgebildet sind.

## Claims

1. A system comprising a plurality of different optoelectronic apparatus (10), each comprising:
a carrier device (12) which has at least one optoelectronic transmitter (40) and/or at least one optoelectronic receiver (42) at an upper side;
a lens element (16) which is provided above the carrier device (12) with respect to a vertical direction and which has at least one lens section (68) for the at least one optoelectronic transmitter (40) and/or for the at least one optoelectronic receiver (42); and
a holding device (82) which holds the carrier device (12) and the lens element (16) relative to one another and partly surrounds the carrier device (12) and the lens element (16),
**characterized in that**
the lens element (16) has a mechanical coding section (60) which projects out of the holding device (82) and which has at least one coding element (62, 63) for identifying the optoelectronic apparatus (10),
with the mechanical coding sections (60) of the lens elements (16) of at least some of the different optoelectronic apparatus (10) differing from one another with respect to the at least one coding element (62, 63).

2. A system according to claim 1,
wherein, in each of the plurality of different optoelectronic apparatus (10), the at least one coding element (62, 63) has at least one elevated portion and/or at least one recess of the mechanical coding section (60), wherein the mechanical coding section (60) has a ring-shaped structure and the at least one coding element (62, 63) is provided at an outer periphery and/or at an inner periphery and/or at an end face of the ring-shaped structure.

3. A system according to claim 1 or 2,
wherein, in each of the plurality of different optoelectronic apparatus (10), the coding section (60) and the at least one lens section (68) are integrally formed with the lens element (16).

4. A system according to at least one of the claims 1 to 3,
wherein, within the system, the holding devices (82) and/or the carrier devices (12) of the plurality of different optoelectronic apparatus (10) are identically formed.

## Revendications

1. Système comprenant plusieurs dispositifs optoélectroniques différents (10) comportant chacun :
un moyen porteur (12) comprenant sur une face supérieure au moins un émetteur optoélectronique (40) et/ou au moins un récepteur optoélectronique (42) ;
un élément de lentille (16) prévu au-dessus du moyen porteur (12) par rapport à une direction verticale et présentant une portion de lentille (68) pour ledit au moins un émetteur optoélectronique (40) et/ou pour ledit au moins un récepteur optoélectronique (42) ; et
un moyen de maintien (82) qui maintient le moyen porteur (12) et l'élément de lentille (16) l'un par rapport à l'autre et qui les entoure partiellement,
**caractérisé en ce que**
l'élément de lentille (16) comprend une portion de codage mécanique (60) qui fait saillie du moyen de maintien (82) et qui comprend au moins un élément de codage (62, 63) pour identifier le dispositif optoélectronique (10), les portions de codage mécaniques (60) des éléments de lentille (16) de quelques-uns au moins des dispositifs optoélectroniques différents se distinguent en ce qui concerne ledit au moins un élément de codage (62, 63).

2. Système selon la revendication 1,
dans lequel, dans chacun desdits plusieurs dispositifs optoélectroniques différents (10), ledit au moins un élément de codage (62, 63) présente au moins un bossage et/ou au moins un renfoncement de la portion de codage mécanique (60),
la portion de codage mécanique (60) présente une structure annulaire, et ledit au moins un élément de codage (62, 63) est prévu sur une périphérie extérieure et/ou sur une périphérie intérieure et/ou sur une face frontale de la structure annulaire.

3. Système selon la revendication 1 ou 2,
dans lequel, dans chacun desdits plusieurs dispositifs optoélectroniques différents (10), la portion de codage (60) et ladite au moins une portion de lentille (68) sont réalisées intégralement avec l'élément de lentille (16).

4. Système selon l'une au moins des revendications 1 à 3,
dans lequel, au sein du système, les moyens de maintien (82) et/ou les moyens porteurs (12) desdits plusieurs dispositifs optoélectroniques différentes (10) sont réalisés de façon identique.
